# EUROPÄISCHE PATENTSCHRIFT

(11) **EP 3 847 751 B1**
(45) Veröffentlichungstag und Bekanntmachung des Hinweises auf die Patenterteilung: **03.08.2022**
(21) Anmeldenummer: 19829154.4
(22) Anmeldetag: 19.12.2019
(51) Int. Cl.: H03K 17/08, H03K 17/14, H03K 17/30

(54) **BETREIBEN EINES LEISTUNGSHALBLEITERELEMENTS**
OPERATION OF A SEMICONDUCTOR ELEMENT
FONCTIONNEMENT D'UN ÉLÉMENT À SEMI-CONDUCTEUR DE PUISSANCE

(30) Priorität: 27.12.2018 EP 18248049
(43) Veröffentlichungstag der Anmeldung: 14.07.2021
(73) Patentinhaber: Siemens Aktiengesellschaft, 80333 München (DE)
(72) Erfinder: WEIS, Benno, 91334 Hemhofen (DE); DIEPOLD, Fabian, 93336 Altmannstein (DE)
(86) Internationale Anmeldenummer: PCT/EP2019/086150
(87) Internationale Veröffentlichungsnummer: WO 2020/136066

(56) Entgegenhaltungen:
- NL-A- 2 020 745
- US-A1- 2011 304 360
- US-A1- 2012 194 226

## Beschreibung

Die Erfindung betrifft ein Verfahren zum Betreiben eines selbstsperrenden oder selbstleitenden Leistungshalbleiterelements.

Bei bestimmten selbstsperrenden oder selbstleitenden Leistungshalbeiterelementen, deren aktiver Bereich z.B. eine Galliumnitirdschicht ist und deren Substrat aus Silizium oder einem anderen Material gefertigt ist, kann sich im Lauf der Zeit die Thresholdspannung ändern. Dadurch steigen die Durchlassverluste im eingeschalteten Zustand des Leistungshalbleiterelements an, wenn das Leistungshalbleiterelement immer mit einer definierten Einschaltgatespannung eingeschaltet wird. Die Erhöhung der Durchlassverluste reduziert die Effizienz des Leistungshalbleiterelements und kann zu einer Überhitzung und einem Ausfall führen.

NL 2020745 A offenbart eine Schaltelement-Steuerschaltung, die konfiguriert ist, einen Messmodus, in dem eine Thresholdspannung eines Schaltelements gemessen wird, und einen Steuermodus, in dem ein EIN/AUS-Betrieb des Schaltelements gesteuert wird, durchzuführen.

US 2012/194226 A1 offenbart eine Schaltelement-Steuervorrichtung, mit der ein Schaltelement angesteuert wird, indem eine Spannung an seinem Steueranschluss in Reaktion auf charakteristische Informationen des Schaltelements gesteuert wird. Die Vorrichtung enthält eine Konstantstromschaltung, die einen konstanten Strom an den Steueranschluss anlegt, eine Spannungsbegrenzungsschaltung, die die Spannung am Steueranschluss auf eine Grenzspannung begrenzt, und eine Steuerschaltung, die die Konstantstromschaltung und die Spannungsbegrenzungsschaltung steuert, um den konstanten Strom an den Steueranschluss zu legen, wenn ein Ansteuersignal zum Einschalten des Schaltelements empfangen wurde, und die Spannung am Steueranschluss für eine Spannungsbegrenzungszeitdauer zu begrenzen. Die Steuerschaltung weist einen Speicher auf, der die charakteristischen Informationen speichert, und stellt in Reaktion auf die charakteristischen Informationen die Grenzspannung, die Spannungsbegrenzungszeitdauer und/oder den konstanten Strom ein.

US 2011/304360 A1 offenbart eine Diodenschaltung mit einem Anodenanschluss, einem Kathodenanschluss, einem Transistor, der einen Gate-Anschluss, einen Drain-Anschluss und einen Source-Anschluss aufweist, und einer Gate-Spannungserzeugungsschaltung, die zwischen den Gate-Anschluss und den Anodenanschluss geschaltet ist und eine mit einer Thresholdspannung des Transistors übereinstimmende Gate-Spannung für den Gate-Anschluss liefert.

Der Erfindung liegt die Aufgabe zugrunde, ein verbessertes Verfahren zum Betreiben eines selbstsperrenden oder selbstleitenden Leistungshalbleiterelements anzugeben, dessen Thresholdspannung sich im Laufe der Zeit ändert.

Die Aufgabe wird erfindungsgemäß durch ein Verfahren mit den Merkmalen des Anspruchs 1 und einen Gate-Treiber mit den Merkmalen des Anspruchs 9 gelöst.

Vorteilhafte Ausgestaltungen der Erfindung sind Gegenstand der Unteransprüche.

Bei dem erfindungsgemäßen Verfahren zum Betreiben eines selbstsperrenden oder selbstleitenden Leistungshalbleiterelements wird eine Thresholdspannungsänderung einer Thresholdspannung des Leistungshalbleiterelements gegenüber einer Referenz-Thresholdspannung ermittelt, und eine Einschaltgatespannung, die zum Einschalten des Leistungshalbleiterelements zwischen einem Gate-Anschluss und einem Source-Anschluss des Leistungshalbleiterelements angelegt wird, wird um die Thresholdspannungsänderung gegenüber einer zu der Referenz-Thresholdspannung korrespondierenden Referenz-Einschalt-gatespannung geändert.

Die Erfindung sieht also vor, eine Thresholdspannungsänderung einer Thresholdspannung eines Leistungshalbleiterelements zu ermitteln und eine Einschaltgatespannung zum Einschalten des Leistungshalbleiterelements an die geänderte Thresholdspannung anzupassen, indem die Einschaltgatespannung um die ermittelte Thresholdspannungsänderung geändert wird. Dadurch wird verhindert, dass sich Durchlassverluste des Leistungshalbleiterelements bei einer Änderung der Thresholdspannung erhöhen, indem die Änderung der Thresholdspannung durch eine entsprechende Nachführung der Einschaltgatespannung ausgeglichen wird. Mit anderen Worten werden die Durchlassverluste des Leistungshalbleiterelements durch eine Nachführung der Einschaltgatespannung unabhängig von der Änderung der Thresholdspannung gehalten. Dadurch wird eine Alterung des Leistungshalbleiterelements verlangsamt und die Lebensdauer des Leistungshalbleiterelements wird vorteilhaft erhöht. Außerdem kann durch das Ermitteln der Thresholdspannungsänderung ein aktueller Zustand des Leistungshalbleiterelements ermittelt und überwacht werden.

Eine Ausgestaltung der Erfindung sieht vor, dass zum Ermitteln der Thresholdspannungsänderung eine Test-Drain-Source-Spannung gemessen wird, die bei einer Test-Ausschalt-Gate-spannung, z.B. bei Gatespannung Null, und einem Test-Rückwärtsstrom zwischen einem Drain-Anschluss des Leistungshalbleiterelements und dem Source-Anschluss auftritt, und als Thresholdspannungsänderung eine Abweichung der Test-Drain-Source-Spannung von einer Referenz-Drain-Source-Spannung ermittelt wird, die bei der Test-Ausschalt-Gate-Spannung und dem Test-Rückwärtsstrom zwischen dem Drain-Anschluss und dem Source-Anschluss auftritt, wenn die Thresholdspannung des Leistungshalbleiterelements mit der Referenz-Thresholdspannung übereinstimmt. Unter einem Rückwärtsstrom wird ein Strom verstanden, der die technische Stromrichtung von dem Source-Anschluss zu dem Drain-Anschluss des Leistungshalbleiterelements hat und daher einem bei eingeschaltetem Leistungshalbleiterelement zwischen dem Drain-Anschluss und dem Source-Anschluss fließenden Strom entgegengerichtet ist.

Die vorgenannte Ausgestaltung der Erfindung nutzt aus, dass eine Thresholdspannungsänderung eine entsprechende Änderung der Drain-Source-Spannung bewirkt, die bei einer Test-Ausschalt-Gate-Spannung und einem Test-Rückwärtsstrom zwischen einem Drain-Anschluss des Leistungshalbleiterelements und dem Source-Anschluss auftritt. Daher kann die Thresholdspannungsänderung ermittelt werden, indem eine Änderung der Drain-Source-Spannung bei der Test-Ausschalt-Gate-Spannung und dem Test-Rückwärtsstrom gegenüber einer Referenz-Drain-Source-Spannung gemessen wird. Insbesondere ermöglicht diese Ausgestaltung der Erfindung vorteilhaft, die Thresholdspannungsänderung im Betrieb des Leistungshalbleiterelements zu ermitteln und durch die Änderung der Einschaltgatespannung auszugleichen.

Eine weitere Ausgestaltung der Erfindung sieht vor, die Test-Ausschalt-Gatespannung während der Flussrichtung des Stromes in Rückwärtsrichtung nur kurzzeitig, z.B. weniger als eine Mikrosekunde lang, anzulegen. Dadurch kann für die verbleibende Zeit des Rückstromflusses in einer Pulsperiode von z.B. etwa 20 µs die Gatespannung auf einen positiven Wert gelegt werden, was die Durchlassverluste verringert.

Eine weitere Ausgestaltung der Erfindung sieht vor, dass die Thresholdspannungsänderung an eine übergeordnete Recheneinheit übertragen wird und von der Recheneinheit aus der Thresholdspannungsänderung eine Restlebensdauer des Leistungshalbleiterelements berechnet wird.

Eine weitere Ausgestaltung der Erfindung sieht vor, dass die Referenz-Drain-Source-Spannung gemessen wird, wenn sich das Leistungshalbleiterelement im Zustand seiner Erstinbetriebnahme befindet. Mit anderen Worten sieht diese Ausgestaltung der Erfindung vor, die Änderung der Drain-Source-Spannung bei der Test-Ausschalt-Gatespannung und dem Test-Rückwärtsstrom gegenüber einer Referenz-Drain-Source-Spannung zu ermitteln, die das Leistungshalbleiterelement bei seiner Erstinbetriebnahme hatte. Dadurch wird auch die Thresholdspannungsänderung der Thresholdspannung gegenüber einer Referenz-Thresholdspannung des Leistungshalbleiterelements bei seiner Erstinbetriebnahme ermittelt und die Einschaltgatespannung wird gegenüber einer Referenz-Einschaltgatespannung des Leistungshalbleiterelements bei seiner Erstinbetriebnahme geändert. Dadurch können die Durchlassverluste des Leistungshalbleiterelements über seine gesamte Lebensdauer konstant gehalten werden.

Bei einer weiteren Ausgestaltung der Erfindung wird im Fall, dass das Leistungshalbleiterelement in einem Brückenarm einer Halbbrücke angeordnet ist, in deren anderem Brückenarm ein weiteres Leistungshalbleiterelement angeordnet ist, die Test-Drain-Source-Spannung nur für die kurze Zeit gemessen, während der beide Leistungshalbleiterelemente ausgeschaltet sind. Diese Ausgestaltung der Erfindung nutzt aus, dass eine Wechselsperrzeit, in der beide Leistungshalbleiterelemente ausgeschaltet sind, für einen sicheren Betrieb der Halbbrücke ohnehin erforderlich ist, um Brückenquerzündungen zu verhindern. Diese Wechselsperrzeit entspricht dann der oben erwähnten kurzen Zeitdauer, während der die Test-Ausschalt-Gate-spannung angelegt wird. Es ist daher vorteilhaft, diese Wechselsperrzeit zu nutzen, um die Test-Drain-Source-Spannung zu messen, da dabei für den verbleibenden Teil einer Pulsperiode die Gatespannung auch bei Rückwärtsstrom auf einen positiven Wert gelegt werden kann, was die Durchlassverluste verringert.

Bei einer weiteren Ausgestaltung der Erfindung ist ein aktiver Bereich des Leistungshalbleiterelements aus Galliumnitrid gefertigt. Bei einer weiteren Ausgestaltung der Erfindung ist das Leistungshalbleiterelement ein so genannter High-Electron-Mobility-Transistor (HEMT). Diese Ausgestaltungen der Erfindung berücksichtigen, dass sich gerade bei einem Leistungshalbleiterelement mit einem aus Galliumnitrid bestehenden aktiven Bereich, insbesondere bei einem als ein HEMT ausgebildeten derartigen Leistungshalbleiterelement, die Thresholdspannung im Laufe der Zeit ändert. Das erfindungsgemäße Verfahren eignet sich daher insbesondere vorteilhaft zum Betrieb eines derartigen Leistungshalbleiterelements.

Ein erfindungsgemäßer Gate-Treiber zum Durchführen des erfindungsgemäßen Verfahrens ist dazu ausgebildet, die Einschalt-gatespannung, die zum Einschalten des Leistungshalbleiterelements zwischen dem Gate-Anschluss und dem Source-Anschluss des Leistungshalbleiterelements angelegt wird, um die Thresholdspannungsänderung gegenüber der Referenz-Einschalt-gatespannung zu ändern. Ein derartiger Gate-Treiber ermöglicht die Nachführung der Einschaltgatespannung in Abhängigkeit von der Thresholdspannungsänderung mit den oben bereits genannten Vorteilen.

Beispielsweise legt der Gate-Treiber eine Test-Ausschalt-Gatespannung an den Gate-Anschluss des Leistungshalbleiterelements, wenn ein Test-Rückwärtsstrom zwischen dem Source-Anschluss und einem Drain-Anschluss des Leistungshalbleiterelements fließt.

Ferner weist der Gate-Treiber beispielsweise eine Messeinheit auf, die dazu ausgebildet ist, eine Test-Drain-Source-Spannung zu messen, die zwischen dem Drain-Anschluss und dem Source-Anschluss des Leistungshalbleiterelements auftritt, wenn der Test-Rückwärtsstrom zwischen dem Drain-Anschluss und dem Source-Anschluss fließt und die Test-Ausschalt-Gate-spannung an dem Gate-Anschluss anliegt.

Außerdem kann vorgesehen sein, dass der Gate-Treiber den zuletzt von der Messeinheit gemessenen Wert der Test-Drain-Source-Spannung speichert.

Ferner kann vorgesehen sein, dass der Gate-Treiber die Einschaltgatespannung als Summe einer Referenz-Gatespannung und des zuletzt von der Messeinheit gemessenen Wertes der Test-Drain-Source-Spannung bildet. Die Referenz-Gatespannung wird vorzugsweise so gewählt, dass die Summe der Referenz-Gate-spannung und der Referenz-Drain-Source-Spannung, die bei der Test-Ausschalt-Gatespannung und dem Test-Rückwärtsstrom zwischen dem Drain-Anschluss und dem Source-Anschluss im Zustand der Erstinbetriebnahme des Leistungshalbleiterelements gemessen wurde, die Referenz-Einschalt-Gatespannung ergibt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 eine schematische Schnittdarstellung eines selbstsperrenden Leistungshalbleiterelements,
FIG 2 ein Ablaufdiagramm des erfindungsgemäßen Verfahrens,
FIG 3 einen Schaltplan einer Halbbrückenschaltung zweier selbstsperrender Leistungshalbleiterelemente,
FIG 4 einen Schaltplan eines Gate-Treibers gemäß dem Stand der Technik, der ein Leistungshalbleiterelement steuert, und
FIG 5 einen Schaltplan eines Ausführungsbeispiels eines erfindungsgemäßen Gate-Treibers, der ein Leistungshalbleiterelement steuert.

Einander entsprechende Teile sind in den Figuren mit denselben Bezugszeichen versehen.

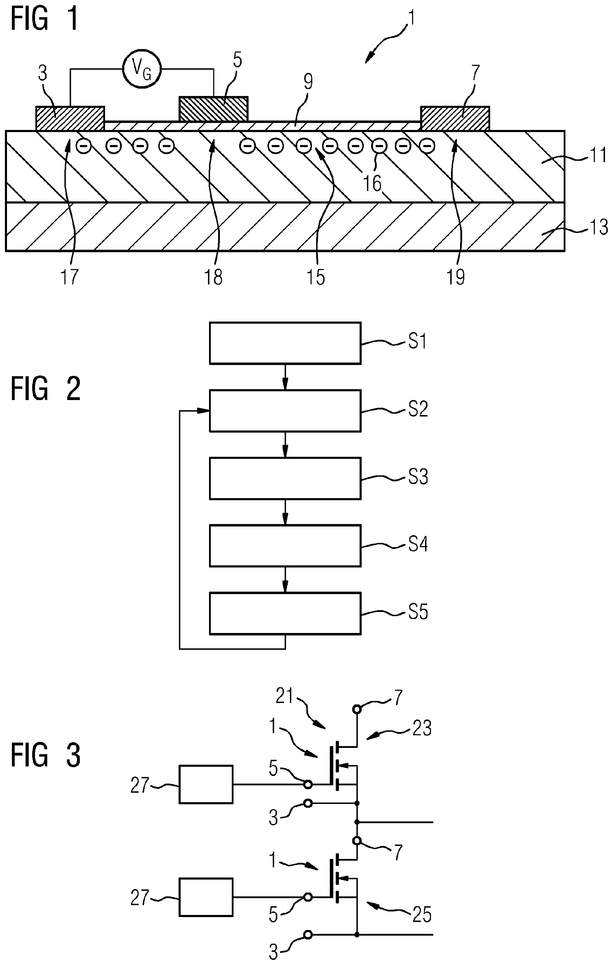

Figur 1 zeigt eine schematische Schnittdarstellung eines beispielsweise selbstsperrenden Leistungshalbleiterelements 1.

Das Leistungshalbleiterelement 1 (z.B. ein als ein HEMT ausgebildeter Galliumnitrid-Schalter) weist einen Source-Anschluss 3, einen Gate-Anschluss 5 und einen Drain-Anschluss 7 auf. Zwischen dem Source-Anschluss 3 und dem Drain-Anschluss 7 verläuft eine Zwischenschicht 9 aus Aluminiumgalliumnitrid (AlGaN). Der Source-Anschluss 3, der Drain-Anschluss 7 und die Zwischenschicht 9 sind auf einem aktiven Bereich 11, beispielsweise einer Galliumnitridschicht, angeordnet, der auf einem Träger 13 (dem sogenannten Substrat) aus zum Beispiel Silizium (Si) aufgebracht ist. Der Gate-Anschluss 5 ist auf der Zwischenschicht 9 zwischen dem Source-Anschluss 3 und dem Drain-Anschluss 7 angeordnet.

Das Leistungshalbleiterelement 1 leitet zwischen dem Drain-Anschluss 7 und dem Source-Anschluss 3 üblicherweise dadurch, dass sich unterhalb der Zwischenschicht 9 in dem aktiven Bereich 11 durch den piezoelektrischen Effekt aufgrund einer mechanischen Spannung zwischen der Zwischenschicht 9 und dem aktiven Bereich 11 ein leitfähiger Kanal 15 aus Elektronen 16 zwischen einer Stelle 17 unterhalb des Source-Anschlusses 3 und einer Stelle 19 unterhalb des Drain-Anschlusses 7 bildet. Die Stelle 17 definiert das elektrische Bezugspotenzial, auf das im Folgenden die elektrischen Spannungen bezogen sind. Der Kanal 15 mit konzentrierten Elektronen 16 wird üblicherweise als zweidimensionale Elektronengas-Schicht (2DEG-Schicht) bezeichnet.

Wird die Zwischenschicht 9 an einer Stelle dünner ausgeführt oder wird an einer Stelle 18 in dem aktiven Bereich 11 unterhalb des Gate-Anschlusses 5 durch eine negative Gatespannung V_{G} zwischen dem Gate-Anschluss 5 und dem Source-Anschluss 3 ein negatives elektrisches Potenzial eingeprägt, so unterbricht dieses den leitfähigen Kanal 15. Die Höhe des eingebrachten Potenzials hängt von der Struktur der Zwischenschicht 9 ab und beträgt beispielsweise -2 V. Ist das Potenzial an der Stelle 19 Null oder positiv, so werden die Elektronen 16 von dem niedrigen Potenzial an der Stelle 18 abgestoßen und der Kanal 15 unterbrochen. Dadurch sperrt das Leistungshalbleiterelement 1.

Wird nun auf der Oberseite der Zwischenschicht 9 das Potenzial durch eine externe Gatespannung V_{G} angehoben, so kann das Potenzial unter der Zwischenschicht 9 wieder soweit steigen, dass die Elektronen 16 nicht mehr abgestoßen werden und wieder ein leitfähiger Kanal 15 entsteht. Damit kann das Leistungshalbleiterelement 1 eingeschaltet werden. Die Spannung, um die das Potenzial angehoben werden muss, um das Leistungshalbleiterelement 1 einzuschalten, wird als Thresholdspannung bezeichnet. Die Thresholdspannung kann sich im Lauf der Zeit z.B. durch Veränderungen in der Struktur der Zwischenschicht 9 ändern. Wird das Leistungshalbleiterelement 1 mit einer immer gleichen Gatespannung V_{G} eingeschaltet, so führt ein Anstieg der Thresholdspannung dazu, dass das Potenzial an der Stelle 18 weniger ansteigt als im Originalzustand des Leistungshalbleiterelements 1 bei dessen Erstinbetriebnahme. Damit steigen die Durchlassverluste im eingeschalteten Zustand des Leistungshalbleiterelements 1 an, was die Effizienz der Schaltung reduziert und zu einer Überhitzung und einem Ausfall des Leistungshalbleiterelements 1 führen kann.

Im Normalbetrieb ist das Leistungshalbleiterelement 1 bei einer Ausschalt-Gatespannung von z.B. Null Volt ausgeschaltet. Auch bei der Ausschalt-Gatespannung kann jedoch ein leitfähiger Kanal 15 ausgebildet werden, wenn das Potenzial an der Stelle 19 um mehr als die Thresholdspannung sinkt. Dann ist das Potenzial an der Stelle 19 nämlich niedriger als an der Stelle 18, wo es im ausgeschalteten Zustand beispielsweise - 2 V beträgt. Damit fließen Elektronen 16 von dem Drain-Anschluss 7 zu den Stellen 18 und 17 und bilden wieder einen leitfähigen Kanal 15, so dass das Leistungshalbleiterelement 1 leitet. Ein derartiger Strom hat die technische Stromrichtung von dem Source-Anschluss 3 zu dem Drain-Anschluss 7 und wird als Rückwärtsstrom bezeichnet, da er einem bei eingeschaltetem Leistungshalbleiterelement 1 zwischen dem Drain-Anschluss 7 und dem Source-Anschluss 3 fließenden Strom entgegengerichtet ist.

Bei einem Rückwärtsstrom setzt sich der Betrag des negativen Potenzials an der Stelle 19 aus der Thresholdspannung und einem ohmschen Spannungsabfall an dem Kanal 15 zusammen. Da sich der Wert des ohmschen Spannungsabfalls mit der Zeit nicht ändert, kann eine Thresholdspannungsänderung der Thresholdspannung des Leistungshalbleiterelements 1 daher durch eine Änderung der Drain-Source-Spannung ermittelt werden, die bei einer definierten Test-Ausschalt-Gatespannung von z.B. Null Volt und einem definierten Test-Rückwärtsstrom zwischen dem Drain-Anschluss 7 und dem Source-Anschluss 3 auftritt. Beträgt beispielsweise ein Jahr nach der Erstinbetriebnahme des Leistungshalbleiterelements 1 die Drain-Source-Spannung bei der Test-Ausschalt-Gatespannung und dem Test-Rückwärtsstrom -2 V statt wie ursprünglich (bei der Erstinbetriebnahme des Leistungshalbleiterelements 1) -1.5 V, so kann daraus geschlossen werden, dass die Thresholdspannung um 0,5 V angestiegen ist. Dies wird bei dem erfindungsgemäßen Verfahren ausgenutzt.

Figur 2 zeigt ein Ablaufdiagramm des erfindungsgemäßen Verfahrens zum Betreiben eines in Figur 1 dargestellten selbstsperrenden Leistungshalbleiterelements 1.

In einem ersten Verfahrensschritt S1 wird im Zustand der Erstinbetriebnahme des Leistungshalbleiterelements 1 eine Referenz-Drain-Source-Spannung gemessen, die bei einer Test-Ausschalt-Gatespannung von z.B. Null Volt und einem Test-Rückwärtsstrom zwischen dem Drain-Anschluss 7 und dem Source-Anschluss 3 auftritt.

In einem zweiten Verfahrensschritt S2 wird zu einem späteren Zeitpunkt eine Test-Drain-Source-Spannung gemessen, die bei derselben Test-Ausschalt-Gatespannung und demselben Test-Rückwärtsstrom wie im ersten Verfahrensschritt S1 auftritt. In einem dritten Verfahrensschritt S3 wird eine Abweichung der in dem zweiten Verfahrensschritt S2 gemessenen Test-Drain-Source-Spannung von der in dem ersten Verfahrensschritt S1 gemessenen Referenz-Drain-Source-Spannung ermittelt. Diese Abweichung gibt die Thresholdspannungsänderung der Thresholdspannung des Leistungshalbleiterelements 1 gegenüber einer Referenz-Thresholdspannung an, die das Leistungshalbleiterelement 1 zum Zeitpunkt der Durchführung des ersten Verfahrensschritts Sl, das heißt im Zustand seiner Erstinbetriebnahme, hatte.

In einem vierten Verfahrensschritt S4 wird eine Einschaltgatespannung, die zum Einschalten des Leistungshalbleiterelements 1 zwischen dem Gate-Anschluss 5 und dem Source-Anschluss 3 des Leistungshalbleiterelements 1 angelegt wird, um die in dem dritten Verfahrensschritt S3 ermittelte Thresholdspannungsänderung gegenüber einer Referenz-Einschaltgatespannung geändert, welche zu der Referenz-Thresholdspannung korrespondiert und mit welcher das Leistungshalbleiterelement 1 bei seiner Erstinbetriebnahme eingeschaltet wurde. Wenn die Thresholdspannung beispielsweise um 0,5 V gegenüber der Referenz-Thresholdspannung angestiegen ist, wird auch die Einschaltgatespannung gegenüber der Referenz-Einschaltgatespannung um 0,5 V angehoben und das Leistungshalbleiterelement 1 wird mit der geänderten Einschaltgatespannung eingeschaltet.

In einem optionalen fünften Verfahrensschritt S5 wird die Änderung der Thresholdspannung an eine übergeordnete Recheneinheit übermittelt, welche aus dieser Information eine Restlebensdauer des Leistungshalbleiterelements 1 berechnet.

Nach dem fünften Verfahrensschritt S5 wird nach einer geeignet gewählten Zeitdauer wieder der zweite Verfahrensschritt S2 ausgeführt, um zu überprüfen, ob sich die Thresholdspannung weiter geändert hat, und die Einschaltgatespannung gegebenenfalls an die geänderte Thresholdspannung anzupassen sowie die Restlebensdauer neu zu berechnen.

Figur 3 zeigt einen Schaltplan einer Halbbrücke 21, in deren Brückenarmen 23, 25 jeweils ein wie in Figur 1 ausgebildetes Leistungshalbleiterelement 1 angeordnet ist, dessen Gate-Anschluss 5 durch einen Gate-Treiber 27 angesteuert wird. Für jedes Leistungshalbleiterelement 1 wird das anhand der Figur 2 beschriebene Verfahren durchgeführt. Dabei wird der zweite Verfahrensschritt S2 jeweils während einer Wechselsperrzeit ausgeführt, in der beide Leistungshalbleiterelemente 1 ausgeschaltet sind. Diese Wechselsperrzeit ist für einen sicheren Betrieb der Halbbrücke 21 ohnehin erforderlich, um Brückenquerzündungen zu verhindern. Zur Messung der Test-Drain-Source-Spannung eines Leistungshalbleiterelements 1 kann beispielsweise eine kurzzeitige Speicherung eines Spannungswertes zwischen dem Drain-Anschluss 7 und dem Source-Anschluss 3 durch eine Spitzenwerterkennung durchgeführt werden. Jeder Gate-Treiber 27 ist dazu ausgebildet, die Einschaltgatespannung, die zum Einschalten des jeweiligen Leistungshalbleiterelements 1 zwischen dem Gate-Anschluss 5 und dem Source-Anschluss 3 des Leistungshalbleiterelements 1 angelegt wird, um die Thresholdspannungsänderung, die in dem dritten Verfahrensschritt S3 des anhand der Figur 2 beschriebenen Verfahrens ermittelt wird, gegenüber der Referenz-Einschaltgatespannung zu ändern und das Leistungshalbleiterelement 1 mit der geänderten Einschaltgatespannung einzuschalten.

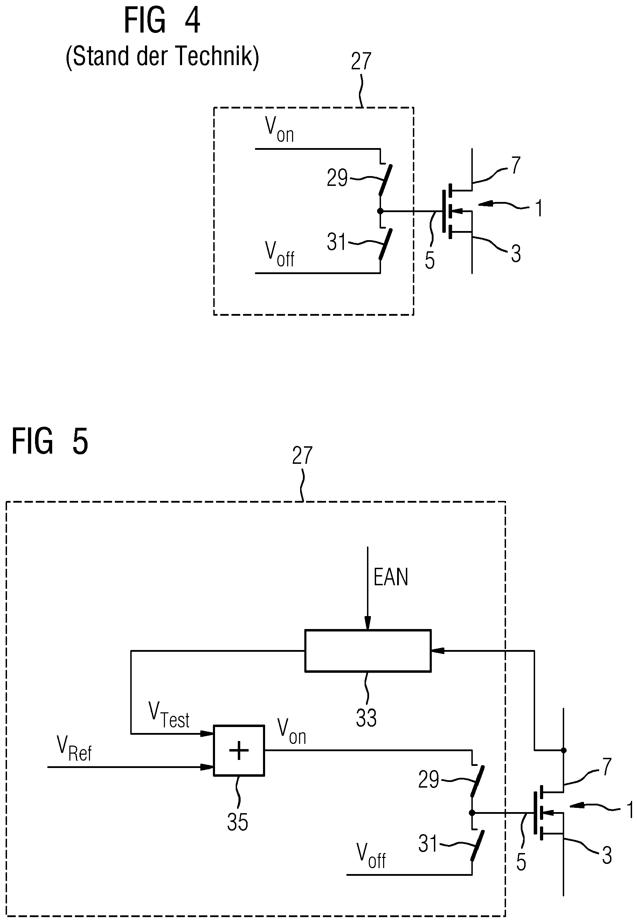

Figur 4 zeigt schematisch einen Gate-Treiber 27 gemäß dem Stand der Technik, der ein wie in Figur 1 ausgebildetes Leistungshalbleiterelement 1 steuert. Der Gate-Treiber 27 weist zwei Schalter 29, 31 zum Ansteuern des Gate-Anschlusses 5 des Leistungshalbleiterelements 1 auf. Um das Leistungshalbleiterelement 1 einzuschalten, wird ein erster Schalter 29 geschlossen und der zweite Schalter 31 wird geöffnet, wodurch eine Einschaltgatespannung Vₒₙ an den Gate-Anschluss 5 gelegt wird. Um das Leistungshalbleiterelement 1 auszuschalten, wird der erste Schalter 29 geöffnet und der zweite Schalter 31 wird geschlossen, wodurch eine Ausschaltgatespannung V_{off} an den Gate-Anschluss 5 angelegt wird. Die Einschaltgatespannung Vₒₙ bleibt während der gesamten Betriebszeit des Leistungshalbleiterelements 1 unverändert.

Figur 5 zeigt schematisch ein Ausführungsbeispiel eines erfindungsgemäßen Gate-Treibers 27, der ein wie in Figur 1 ausgebildetes Leistungshalbleiterelement 1 steuert und zum Durchführen des anhand von Figur 2 beschriebenen Verfahrens ausgebildet ist. Der Gate-Treiber 27 weist zusätzlich zu den Komponenten eines Gate-Treibers 27 gemäß dem Stand der Technik eine Messeinheit 33 und eine Addiereinheit 35 auf.

Wenn der Test-Rückwärtsstrom zwischen dem Drain-Anschluss 7 und dem Source-Anschluss 3 des Leistungshalbleiterelements 1 fließt, legt der Gate-Treiber 27 als Ausschaltgatespannung V_{off} über den zweiten Schalter 31 bei geöffnetem ersten Schalter 29 die Test-Ausschalt-Gatespannung an den Gate-Anschluss 5 und misst mit der Messeinheit 33 eine Test-Drain-Source-Spannung V_{Test}, die zwischen dem Drain-Anschluss 7 und dem Source-Anschluss 3 auftritt. Der gemessene Wert der Test-Drain-Source-Spannung V_{Test} wird von der Messeinheit 33 bis zur nächsten Messung der Test-Drain-Source-Spannung V_{Test} gespeichert.

Die Messeinheit 33 ist beispielsweise als eine aus dem Stand der Technik bekannte so genannte Sättigungsüberwachungsschaltung ausgebildet. Die Messeinheit 33 wird durch ein Enable-Signal EAN aktiviert und deaktiviert, das einen Aktivierungswert und einen Deaktivierungswert annehmen kann. Das Enable-Signal EAN wird nur dann auf den Aktivierungswert gesetzt, wenn der Test-Rückwärtsstrom zwischen dem Drain-Anschluss 7 und dem Source-Anschluss 3 fließt und die Test-Ausschalt-Gatespannung an dem Gate-Anschluss 5 liegt. Wenn das Enable-Signal EAN den Aktivierungswert annimmt, wird von der Messeinheit 33 die Test-Drain-Source-Spannung V_{Test} gemessen und der gemessene Wert der Test-Drain-Source-Spannung V_{Test} wird gespeichert. Wenn das Enable-Signal EAN den Deaktivierungswert annimmt, wird der zuletzt gespeicherte Wert der Test-Drain-Source-Spannung V_{Test} von einem Ausgang der Messeinheit 33 an die Addiereinheit 35 ausgegeben.

Zum Einschalten des Leistungshalbleiterelements 1 wird über den ersten Schalter 29 bei geöffnetem zweiten Schalter 31 eine Einschaltgatespannung Vₒₙ an den Gate-Anschluss 5 gelegt, die von der Addiereinheit 35 als Summe einer Referenz-Gate-spannung V_{Ref} und des zuletzt von der Messeinheit 33 gespeicherten Wertes der Test-Drain-Source-Spannung V_{Test} gebildet wird. Die Addiereinheit 35 kann entweder in analoger oder in digitaler Technik ausgeführt sein.

Die Referenz-Gatespannung V_{Ref} wird vorzugsweise so gewählt, dass sie in Summe mit der Referenz-Drain-Source-Spannung, die bei der Test-Ausschalt-Gatespannung und dem Test-Rückwärtsstrom zwischen dem Drain-Anschluss 7 und dem Source-Anschluss 3 im Zustand der Erstinbetriebnahme des Leistungshalbleiterelements 1 gemessen wurde, die Referenz-Einschalt-Gatespannung ergibt. Ändert sich nun die Test-Drain-Source-Spannung V_{Test} im Laufe der Zeit, wird die Einschaltgatespannung Vₒₙ entsprechend nachgeführt.

## Patentansprüche

1. Verfahren zum Betreiben eines selbstsperrenden oder selbstleitenden Leistungshalbleiterelements (1), wobei
- eine Thresholdspannungsänderung einer Thresholdspannung des Leistungshalbleiterelements (1) gegenüber einer Referenz-Thresholdspannung ermittelt wird und
- eine Einschaltgatespannung (Vₒₙ), die zum Einschalten des Leistungshalbleiterelements (1) zwischen einem Gate-Anschluss (5) und einem Source-Anschluss (3) des Leistungshalbleiterelements (1) angelegt wird, um die Thresholdspannungsänderung gegenüber einer zu der Referenz-Thresholdspannung korrespondierenden Referenz-Einschaltgatespannung geändert wird,
**dadurch gekennzeichnet, dass**
zum Ermitteln der Thresholdspannungsänderung eine Test-Drain-Source-Spannung (V_{Test}) gemessen wird, die bei einer Test-Ausschalt-Gatespannung und einem Test-Rückwärtsstrom zwischen einem Drain-Anschluss (7) des Leistungshalbleiterelements (1) und dem Source-Anschluss (3) auftritt, und als Thresholdspannungsänderung eine Abweichung der Test-Drain-Source-Spannung (V_{Test}) von einer Referenz-Drain-Source-Spannung ermittelt wird, die bei der Test-Ausschalt-Gatespannung und dem Test-Rückwärtsstrom zwischen dem Drain-Anschluss (7) und dem Source-Anschluss (3) auftritt, wenn die Thresholdspannung des Leistungshalbleiterelements (1) mit der Referenz-Thresholdspannung übereinstimmt.

2. Verfahren nach Anspruch 1, wobei die Test-Ausschalt-Gatespannung Null Volt beträgt.

3. Verfahren nach Anspruch 1 oder 2, wobei die Test-Drain-Source-Spannung (V_{Test}) weniger als eine Mikrosekunde lang gemessen wird.

4. Verfahren nach einem der vorhergehenden Ansprüche, wobei die Thresholdspannungsänderung an eine übergeordnete Recheneinheit übertragen wird und von der Recheneinheit aus der Thresholdspannungsänderung eine Restlebensdauer des Leistungshalbleiterelements (1) berechnet wird.

5. Verfahren nach einem der vorhergehenden Ansprüche, wobei die Referenz-Drain-Source-Spannung gemessen wird, wenn sich das Leistungshalbleiterelement (1) im Zustand seiner Erstinbetriebnahme befindet.

6. Verfahren nach einem der vorhergehenden Ansprüche, wobei im Fall, dass das Leistungshalbleiterelement (1) in einem Brückenarm (23, 25) einer Halbbrücke (21) angeordnet ist, in deren anderem Brückenarm (25, 23) ein weiteres Leistungshalbleiterelement (1) angeordnet ist, die Test-Drain-Source-Spannung (V_{Test}) gemessen wird, während beide Leistungshalbleiterelemente (1) ausgeschaltet sind.

7. Verfahren nach einem der vorhergehenden Ansprüche, wobei ein aktiver Bereich (11) des Leistungshalbleiterelements (1) aus Galliumnitrid gefertigt ist.

8. Verfahren nach einem der vorhergehenden Ansprüche, wobei das Leistungshalbleiterelement (1) ein High-Electron-Mobility-Transistor ist.

9. Gate-Treiber (27) zum Durchführen des Verfahrens nach einem der vorhergehenden Ansprüche, wobei der Gate-Treiber (27) dazu ausgebildet ist, die Einschaltgatespannung (Vₒₙ), die zum Einschalten des Leistungshalbleiterelements (1) zwischen dem Gate-Anschluss (5) und dem Source-Anschluss (3) des Leistungshalbleiterelements (1) angelegt wird, um die Thresholdspannungsänderung gegenüber der Referenz-Einschaltgatespannung zu ändern.

10. Gate-Treiber (27) nach Anspruch 9, der eine Test-Ausschalt-Gatespannung an den Gate-Anschluss (5) des Leistungshalbleiterelements (1) anlegt, wenn ein Test-Rückwärtsstrom zwischen dem Source-Anschluss (3) und einem Drain-Anschluss (7) des Leistungshalbleiterelements (1) fließt.

11. Gate-Treiber (27) nach Anspruch 10 mit einer Messeinheit (33), die dazu ausgebildet ist, eine Test-Drain-Source-Spannung (V_{Test}) zu messen, die zwischen dem Drain-Anschluss (7) und dem Source-Anschluss (3) des Leistungshalbleiterelements (1) auftritt, wenn der Test-Rückwärtsstrom zwischen dem Drain-Anschluss (7) und dem Source-Anschluss (3) fließt und die Test-Ausschalt-Gatespannung an dem Gate-Anschluss (5) anliegt.

12. Gate-Treiber (27) nach Anspruch 11, der den zuletzt von der Messeinheit (33) gemessenen Wert der Test-Drain-Source-Spannung (V_{Test}) speichert.

13. Gate-Treiber (27) nach Anspruch 11 oder 12, der die Einschaltgatespannung (Vₒₙ) als Summe einer Referenz-Gatespannung (V_{Ref}) und des zuletzt von der Messeinheit (33) gemessenen Wertes der Test-Drain-Source-Spannung (V_{Test}) bildet.

## Claims

1. Method for operating a self-locking or self-conducting power semiconductor element (1), wherein
- a threshold voltage change of a threshold voltage of the power semiconductor element (1) is determined compared with a reference threshold voltage and
- a switch-on gate voltage (Vₒₙ), which is applied between a gate terminal (5) and a source terminal (3) of the power semiconductor element (1) in order to switch on the power semiconductor element (1), is changed by the threshold voltage change compared with a reference switch-on gate voltage which corresponds to the reference threshold voltage,
**characterised in that**
in order to determine the threshold voltage change, a test drain source voltage (V_{Test}) is measured, which occurs with a test switch-off gate voltage and a test return current between a drain terminal (7) of the power semiconductor element (1) and the source terminal (3), and as a threshold voltage change a deviation in the test drain source voltage (V_{Test}) from a reference drain source voltage is determined, which occurs with the test switch-off gate voltage and the test return current between the drain terminal (7) and the source terminal (3), if the threshold voltage of the power semiconductor element (1) agrees with the reference threshold voltage.

2. Method according to claim 1, wherein the test switch-off gate voltage amounts to zero volts.

3. Method according to claim 1 or 2, wherein the test drain source voltage (V_{Test}) is measured for less than one microsecond.

4. Method according to one of the preceding claims, wherein the threshold voltage change is transmitted to a high-level computing unit and a residual service life of the power semiconductor element (1) is calculated from the threshold voltage change by the computing unit.

5. Method according to one of the preceding claims, wherein the reference drain source voltage is measured, when the power semiconductor element (1) is in its initial commissioning state.

6. Method according to one of the preceding claims, wherein in the case that the power semiconductor element (1) is arranged in a bridge arm (23, 25) of a half bridge (21), a further power semiconductor element (1) is arranged in the other bridge arm (25, 23), the test drain source voltage (V_{Test}) is measured while both power semiconductor elements (1) are switched off.

7. Method according to one of the preceding claims, wherein an active region (1) of the power semiconductor element (1) is produced from gallium nitride.

8. Method according to one of the preceding claims, wherein the power semiconductor element (1) is a high electron mobility transistor.

9. Gate driver (27) for carrying out the method according to one of the preceding claims, wherein the gate driver (27) is embodied to change the switch-on gate voltage (Vₒₙ), which is applied between the gate terminal (5) and the source terminal (3) of the power semiconductor element (1) in order to switch on the power semiconductor element (1), by the threshold voltage change compared with the reference switch-on gate voltage.

10. Gate driver (27) according to claim 9, which applies a test switch-off gate voltage to the gate terminal (5) of the power semiconductor element (1) if a test return current flows between the source terminal (3) and a drain terminal (7) of the power semiconductor element (1).

11. Gate driver (27) according to claim 10 with a measuring unit (33), which is embodied to measure a test drain source voltage (V_{Test}) which occurs between the drain terminal (7) and the source terminal (3) of the power semiconductor element (1) if the test return current flows between the drain terminal (7) and the source terminal (3) and applies the test switch-off gate voltage to the gate terminal (5).

12. Gate driver (27) according to claim 11, which stores the value of the test drain source voltage (V_{Test}) last measured by the measuring unit (33).

13. Gate driver (27) according to claim 11 or 12, which forms the switch-on gate voltage (Vₒₙ) as a total of a reference gate voltage (V_{Ref}) and the value of the test drain source voltage (V_{Test}) last measured by the measuring unit (33).

## Revendications

1. Procédé pour faire fonctionner un élément (1) à semiconducteur de puissance à enrichissement ou appauvrissement, dans lequel
- on détermine une variation d'une tension de seuil de l'élément (1) à semiconducteur de puissance, par rapport à une tension de seuil de référence, et
- on modifie une tension (Vₒₙ) de grille de déblocage, qui est appliquée pour le déblocage de l'élément (1) à semiconducteur de puissance entre une borne (5) de grille et une borne (3) de source de l'élément (1) à semiconducteur de puissance, de la variation de tension de seuil par rapport à une tension de grille de déblocage de référence correspondant à la tension de seuil de référence,
**caractérisé en ce que**
pour déterminer la variation de la tension de seuil, on mesure une tension (V_{Test}) de drain-source de test, qui apparaît, pour une tension de grille de blocage de test et un courant inverse de test, entre une borne (7) de drain de l'élément (1) à semiconducteur de puissance et la borne (3) de source et on détermine, comme variation de la tension de seuil, un écart de la tension (V_{Test}) de drain-source de test à une tension de drain-source de référence, qui apparaît, à la tension de grille de blocage de test et au courant inverse de test, entre la borne (7) de drain et la borne (3) de source, si la tension de seuil de l'élément (1) à semiconducteur de puissance coïncide avec la tension de seuil de référence.

2. Procédé suivant la revendication 1, dans lequel la tension de grille de blocage de test est égale à zéro volt.

3. Procédé suivant la revendication 1 ou 2, dans lequel on mesure la tension (V_{Test}) de drain-source de test en moins d'une microseconde.

4. Procédé suivant l'une des revendications précédentes, dans lequel on transmet la variation de tension de seuil à une unité informatique supérieure hiérarchiquement et on calcule, par l'unité informatique, une durée de vie résiduelle de l'élément (1) à semiconducteur de puissance, à partir de la variation de la tension de seuil.

5. Procédé suivant l'une des revendications précédentes, dans lequel on mesure la tension de drain-source de référence, si l'élément (1) à semiconducteur de puissance se trouve dans l'état de sa première mise en fonctionnement.

6. Procédé suivant l'une des revendications précédentes, dans lequel, dans le cas où l'élément (1) à semiconducteur de puissance est monté dans un bras (23, 25) d'un demi-pont (21), dans l'autre bras (25, 23) de pont est monté un autre élément (1) à semiconducteur de puissance, on mesure la tension (V_{Test}) de drain-source de test pendant que les deux éléments (1) à semiconducteur de puissance sont bloqués.

7. Procédé suivant l'une des revendications précédentes, dans lequel on fabrique une partie (11) active de l'élément (1) à semiconducteur de puissance en nitrure de gallium.

8. Procédé suivant l'une des revendications précédentes, dans lequel l'élément (1) à semiconducteur de puissance est un transistor à grande mobilité des électrons.

9. Circuit d'attaque (27) de grille pour effectuer le procédé suivant l'une des revendications précédentes, le circuit d'attaque (27) de grille étant constitué pour faire varier, de la variation de la tension de seuil par rapport à la tension de grille de déblocage de référence, la tension (Vₒₙ) de grille de déblocage, qui est appliquée pour débloquer l'élément (1) à semiconducteur de puissance entre la borne (5) de grille et la borne (3) de source de l'élément (1) à semiconducteur de puissance.

10. Circuit d'attaque (27) de grille suivant la revendication 9, qui applique une tension de grille de blocage de test à la borne (5) de grille de l'élément (1) à semiconducteur de puissance, s'il passe un courant inverse de test entre la borne (3) de source et une borne (7) de drain de l'élément (1) à semiconducteur de puissance.

11. Circuit d'attaque (27) d'attaque suivant la revendication 10, comprenant une unité (33) de mesure, qui est constituée pour mesurer une tension (V_{Test}) de drain-source de test, qui apparaît entre la borne (7) de drain et la borne (3) de source de l'élément (1) à semiconducteur de puissance, si le courant inverse de test passe entre la borne (7) de drain et la borne (3) de source et si la tension de grille de blocage de test s'applique à la borne (5) de grille.

12. Circuit d'attaque (27) d'attaque suivant la revendication 11, qui met en mémoire la valeur, mesurée en dernier par l'unité (33) de mesure, de la tension (V_{Test}) de drain-source de test.

13. Circuit d'attaque (27) d'attaque suivant la revendication 11 ou 12, qui forme la tension (Vₒₙ) de grille de déblocage comme somme d'une tension (V_{Ref}) de grille de référence et de la valeur, mesurée en dernier par l'unité (33) de mesure, de la tension (V_{Test}) de drain-source de test.
